# EUROPEAN PATENT APPLICATION

(11) **EP 4 629 761 A1**
(43) Date of publication of application: **08.10.2025**
(21) Application number: 25164596.6
(22) Date of filing: 19.03.2025
(51) Int. Cl.: H05K 7/14

(54) **CIRCUIT BOARD MOUNTING STRUCTURE AND IMAGE FORMING APPARATUS**

(30) Priority: 25.03.2024 JP 2024048172
(71) Applicant: KYOCERA Document Solutions Inc., Osaka-shi, Osaka, 540-8585 (JP)
(72) Inventor: ISHIDO, Kohei, Osaka-shi, 540-8585 (JP)
(74) Representative: Plougmann Vingtoft a/s

(57) **Abstract**

A circuit board (5) has a first side (5a) (5a) and a second side (5b) (5b) that form both edges in a first direction, and a third side (5c) (5c) and a fourth side (5d) (5d) that form both edges in a second direction. The circuit board (5) has a hanging hole (51) and a plurality of screw insertion holes (52). The hanging hole (51) is formed in a portion of an edge portion along the first side (5a) (5a) of the circuit board (5) near the third side (5c) (5c). A mounting portion (6) (6) has a hook (61), a plurality of fastening holes (62), and a rotation restricting portion (63). The hook (61) is inserted into the hanging hole (51). The rotation restricting portion (63) restricts the rotation of the circuit board (5). A dimension of the hanging hole (51) in the first direction is larger than an up-down direction of the hook (61), and a plurality of wire harnesses (8) are wired from the mounting portion (6) (6) side via the outer sides of the third side (5c) (5c) and the fourth side (5d) (5d) of the circuit board (5).

## Description

### INCORPORATION BY REFERENCE

This application is based upon and claims the benefit of priority from the corresponding Japanese Patent Application No. 2024-048172 filed on March 25, 2024, the entire contents of which are incorporated herein by reference.

### BACKGROUND

The present disclosure relates to a circuit board mounting structure for mounting a circuit board on a mounting surface (60) along an up-down direction, and an image forming apparatus.

When a circuit board is fixed to a mounting surface (60) along an up-down direction by a plurality of screws, it is necessary to hold the circuit board so that the circuit board does not fall. That is, in a state in which the circuit board is held in a mounting position along the mounting surface (60), the plurality of screws are fastened into a plurality of fastening holes formed in the mounting surface (60).

In addition, it is also known that a hook is provided on the mounting surface (60), and the plurality of screws are fastened into the plurality of fastening holes in a state in which the circuit board is hooked on the hook.

### SUMMARY

A circuit board mounting structure according to one aspect of the present disclosure includes a board, a mounting portion (6), and a plurality of screws. The circuit board has a first side (5a) and a second side (5b) forming both edges in a first direction, and a third side (5c) and a fourth side (5d) forming both edges in a second direction crossing the first direction. A mounting portion (6) has a mounting surface (60) formed along an up-down direction, to which the circuit board is attached in a state in which the first side (5a) of the circuit board faces upward and the first surface of the circuit board faces the mounting surface (60). The plurality of screws fasten the circuit board to the mounting portion (6). The circuit board has a hanging hole and a plurality of screw insertion holes. The hanging hole is formed in a portion of the edge portion along the first side (5a) close to the third side (5c), through which a part of the mounting portion (6) is inserted. The plurality of screw insertion holes are holes through which the plurality of screws are inserted. The mounting portion (6) has a hook, a plurality of fastening holes, and a rotation restricting portion. The hook protrudes from the mounting surface (60) and is inserted into the hanging hole to support a supported portion that is an edge portion of the hanging hole on the first side (5a) side of the circuit board. The plurality of fastening holes are holes into which the plurality of screws inserted into the plurality of screw insertion holes of the circuit board are fastened. The rotation restricting portion, by coming in contact with the outer edge of the circuit board in a state in which the hook supports the supported portion of the circuit board 5, restricts rotation of the circuit board around the hook inserted through the hanging hole. The hook has a protruding base portion and a separation restricting portion. The protruding base portion protrudes from the mounting surface (60) and supports the supported portion of the circuit board. The separation restricting portion protrudes upward from the tip-end portion of the protruding base portion and restricts movement of the supported portion supported by the protruding base portion in a direction away from the mounting surface (60). A dimension of the hanging hole in the first direction of the circuit board is larger than a dimension of the hook in the up-down direction, and a plurality of wire harnesses are wired from the mounting portion (6) side to a second surface of the circuit board via the outer sides of the third side (5c) and the fourth side (5d) of the circuit board. By bringing the circuit board close to the mounting surface (60) in a state in which the first direction of the circuit board is aligned in the up-down direction, the hook is inserted into the hanging hole and the supported portion is placed on the protruding base portion.

An image forming apparatus according to another aspect of the present disclosure includes a sheet conveying device, a printing device, and the circuit board mounting structure. The sheet conveying device conveys a sheet. The printing device forms an image on the sheet that is conveyed. The circuit board mounting structure is a structure for mounting a circuit board that controls the sheet conveying device or the printing device.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 is a configuration diagram of an image forming apparatus including a circuit board mounting structure according to an embodiment.
FIG. 2 is a front view of a circuit board mounting structure according to an embodiment.
FIG. 3 is a perspective view of a portion of a hook and a first fastening hole in a circuit board mounting structure according to an embodiment.
FIG. 4 is a front view of a part of a circuit board and hook in a board mounting structure according to an embodiment.
FIG. 5 is a side view of an upper edge portion of a circuit board and a hook in a circuit board mounting structure according to an embodiment (state immediately before hanging a hole in the circuit board on the hook).
FIG. 6 is a side view of an upper edge portion of a circuit board and a hook in a circuit board mounting structure according to an embodiment (state while hanging a hole in the circuit board on the hook).
FIG. 7 is a side view of an upper edge portion of a circuit board and a hook in a circuit board mounting structure according to an embodiment (state in which a hanging hole in the circuit board is hung on the hook).
FIG. 8 is a perspective view of a lower edge portion of a circuit board and the rotation restricting portion in a circuit board mounting structure according to an embodiment (state in which the lower edge portion of the circuit board is separated from the rotation restricting portion).
FIG. 9 is a perspective view of a lower edge portion of the circuit board and a rotation restricting portion in a circuit board mounting structure according to an embodiment (state in which the lower edge portion of the circuit board is in contact with the rotation restricting portion).
FIG. 10 is a plan view of a mounting portion (6) and a circuit board in a circuit board mounting structure according to an embodiment (state in which a first side (5a) of the circuit board is brought close to the mounting surface (60)).
FIG. 11 is a plan view of a mounting portion (6) and a circuit board in a circuit board mounting structure according to an embodiment (state in which an upper edge portion of the circuit board is hung on a hook).

### DETAILED DESCRIPTION

Hereinafter, embodiments according to the present disclosure will be described with reference to the drawings. Note that the following embodiments are examples according to the present disclosure and do not limit the technical scope of the present disclosure.

A circuit board mounting structure 50 according to an embodiment constitutes a part of an image forming apparatus 10.

### [Configuration of Image Forming Apparatus 10]

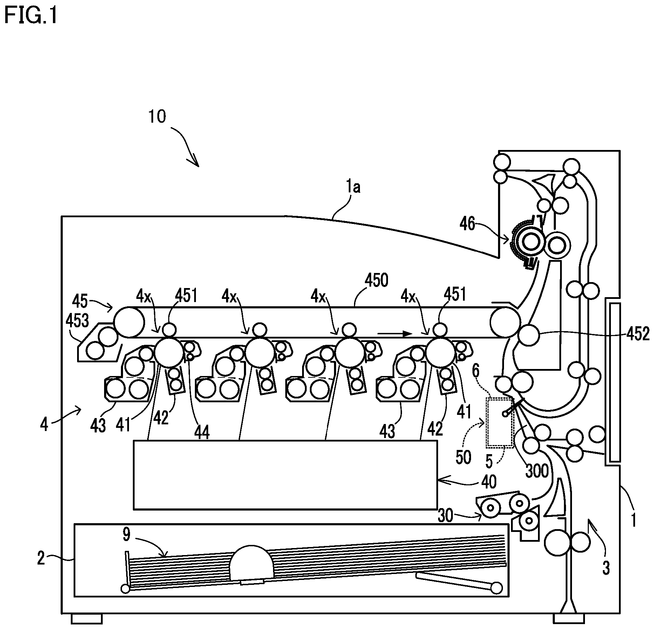

As shown in FIG. 1, an image forming apparatus 10 includes a main housing 1, and a sheet conveying device 3 and a printing device 4 arranged within the main housing 1.

The sheet conveying device 3 conveys a sheet 9. The sheet conveying device 3 includes a sheet supply mechanism 30 and a plurality of sets of conveying roller pairs 31. The sheet supply mechanism 30 sends out the sheets 9 in a sheet storing portion 2 one by one to a sheet conveying path 300. The plurality of sets of conveying roller pairs 31 rotate to convey the sheet 9 along the sheet conveying path 300.

One of the plurality of sets of conveying roller pairs 31 discharges the sheet 9 on which an image has been formed from the sheet conveying path 300 onto a discharge tray 1a.

The printing device 4 forms an image on a sheet 9 conveyed by the sheet conveying device 3. In the example shown in FIG. 1, the printing device 4 forms an image on the sheet 9 by electrophotography.

The electrophotographic printing device 4 includes a laser scanning device 40, one or more image forming portions 4x, a transfer device 45, and a fixing device 46. The image forming portion 4x includes a photoconductor 41, a charging device 42, a developing device 43, a first cleaning device 44, and the like.

The charging device 42 charges the surface of the rotating photoconductor 41. The laser scanning device 40 scans the charged surface of the photoconductor 41 with a laser beam to form an electrostatic latent image on the surface of the photoconductor 41.

The developing device 43 develops the electrostatic latent image formed on the surface of the photoconductor 41 into a toner image. The transfer device 45 transfers the toner image from the surface of the photoreceptor 41 to the sheet 9. The fixing device 46, by applying pressure and heat to the toner image on the sheet 9, fixes the toner image to the sheet 9.

In the example shown in FIG. 1, the printing device 4 is a tandem color printing device. In this case, the printing device 4 includes a plurality of image forming portions 4x corresponding to a plurality of development colors. In addition, the transfer device 45 includes an intermediate transfer belt 450, and a plurality of primary transfer devices 451 and secondary transfer devices 452 corresponding to the plurality of image forming portions 4x.

The plurality of primary transfer devices 451 transfer the toner images from the photoconductors 41 to the surface of the rotating intermediate transfer belt 450 in the plurality of image forming portions 4x. The secondary transfer device 452 transfers the toner image on the surface of the intermediate transfer belt 450 onto the sheet 9.

Note that the printing device 4 may, for example, be a device that forms an image on the sheet 9 by a method other than the electrophotographic method, such as an inkjet method.

In the image forming apparatus 10, the circuit board mounting structure 50 is a structure for mounting the circuit board 5 for controlling the sheet conveying device 3 or the printing device 4 to the mounting portion (6) 6. The circuit board 5 is a printed circuit board such as a control board or a signal processing board.

For example, a motor that rotates the plurality of conveying roller pairs 31 or a motor drive circuit that drives a motor that rotates the photoconductor 41 is mounted on the circuit board 5. Alternatively, a signal processing circuit that processes a detection signal from a sensor such as a sheet sensor that detects the sheet 9 on the sheet conveying path 300 is mounted on the circuit board 5.

In the present embodiment, the circuit board mounting structure 50 is arranged inside a rear cover of the main housing 1.

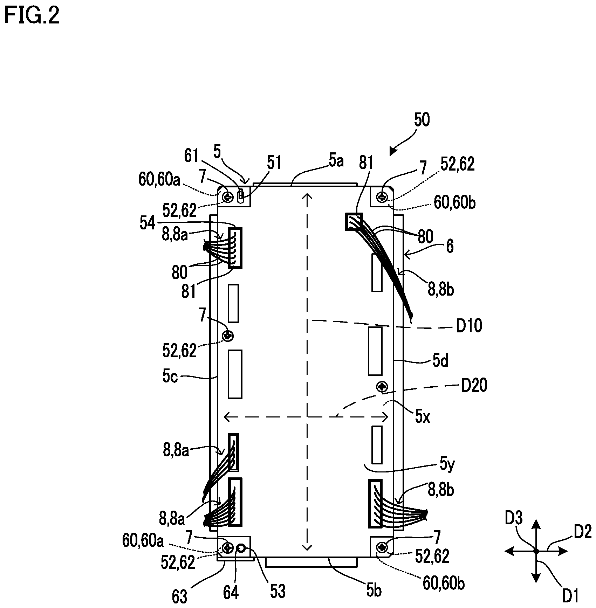

As shown in FIG. 2, in the circuit board mounting structure 50, the mounting portion (6) 6 has a mounting surface (60) 60 along a vertical direction D1. In FIGS. 2 to 11, the vertical direction D1 is the up-down direction.

In the circuit board mounting structure 50, the circuit board 5 is fixed to the mounting portion (6) 6 by a plurality of screws 7 with a first surface 5x of the circuit board 5 aligned along the mounting surface (60) 60. The circuit board 5 is mounted on the mounting portion (6) 6 with the first surface 5x and a second surface 5y of the circuit board 5 aligned along the vertical direction D1. The first surface 5x and the second surface 5y are front and back surfaces of the circuit board 5.

In FIG. 2 to 11, a width direction D2 is a horizontal direction along the mounting surface (60) 60. In addition, a depth direction D3 is a direction perpendicular to the mounting surface (60) 60.

When the circuit board 5 is fixed to the mounting surface (60) 60 along the vertical direction D1 by a plurality of screws 7, it is necessary to hold the circuit board 5 so as not to fall. That is, with the circuit board 5 held in the mounting position along the mounting surface (60) 60, a plurality of screws 7 are fastened into a plurality of fastening holes 62 formed in the mounting surface (60) 60.

Incidentally, there are cases where a plurality of electric wires 80 are wired from the mounting portion (6) 6 side to a front side via the side of the circuit board 5. In this case, when the circuit board 5 is mounted, it is necessary to prevent the plurality of electric wires 80 from being pinched between the circuit board 5 and the mounting portion (6) 6.

In the circuit board mounting structure 50, it is desirable to be able to easily mount the circuit board 5 on the mounting surface (60) 60 along the vertical direction D1 while preventing the plurality of electric wires 80 from being pinched between the circuit board 5 and the mounting surface (60) 60.

### [Circuit Board Mounting Structure 50]

The circuit board mounting structure 50 includes a circuit board 5, a mounting portion (6) 6, and a plurality of screws 7. The circuit board 5 has a first side (5a) 5a and a second side (5b) 5b that form both edges of the circuit board 5 in a first direction D10, and a third side (5c) 5c and a fourth side (5d) 5d that form both edges of the circuit board 5 in a second direction D20 (see FIG. 2).

In the present embodiment, the first direction D10 is the longitudinal direction of the circuit board 5, and the second direction D20 is the lateral direction of the circuit board 5 (see FIG. 2). The second direction D20 crosses the first direction D10. More specifically, the second direction D20 is a direction perpendicular to the first direction D10.

The circuit board 5 is attached to the mounting portion (6) 6 with the first side (5a) 5a facing upward and the first surface 5x facing the mounting surface (60) 60. The circuit board 5 has a hanging hole 51 and a plurality of screw insertion holes 52 (see FIG. 1). The mounting portion (6) 6 has a hook 61, a plurality of fastening holes 62, and a rotation restricting portion 63 (see FIG. 1).

The hanging hole 51 is a hole formed in a portion of an edge portion along the first side (5a) 5a of the circuit board 5, close to the third side (5c) 5c. The hook 61 of the mounting portion (6) 6 is inserted into the hanging hole 51. The plurality of screw insertion holes 52 are holes through which the plurality of screws 7 are inserted.

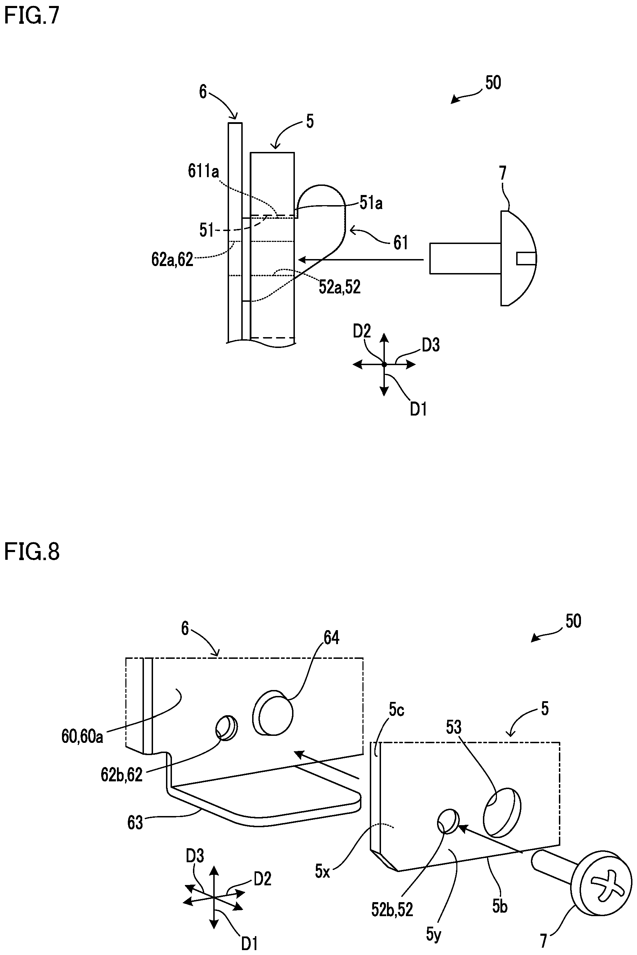

The hook 61 protrudes from the mounting surface (60) 60. The hook 61 is inserted into the hanging hole 51 to support a supported portion 51a of the circuit board 5 (see FIG. 7). The supported portion 51a is an edge portion of the first side (5a) 5a side of the hanging hole 51 in the circuit board 5.

The plurality of fastening holes 62 are holes into which the plurality of screws 7 inserted into the plurality of screw insertion holes 52 of the circuit board 5 are fastened. Fastening holes 62 are holes in which screw threads are formed.

The rotation restricting portion 63, by coming in contact with the outer edge of the circuit board 5 in a state in which the hook 61 supports the supported portion 51a of the circuit board 5, restricts rotation of the circuit board 5 around the hook 61 inserted through the hanging hole 51.

For example, the rotation restricting portion 63 comes in contact with a portion of the second side (5b) 5b of the circuit board 5 closer to the third side (5c) 5c (see FIG. 2). Alternatively, it is also conceivable that the rotation restricting portion 63 comes into contact with a portion of the second side (5b) 5b of the circuit board 5 closer to the fourth side (5d) 5d.

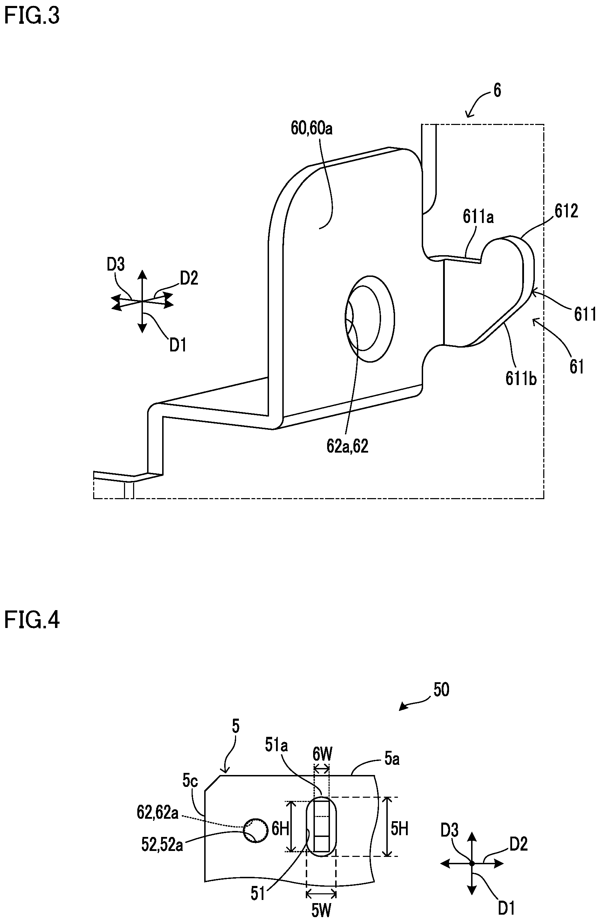

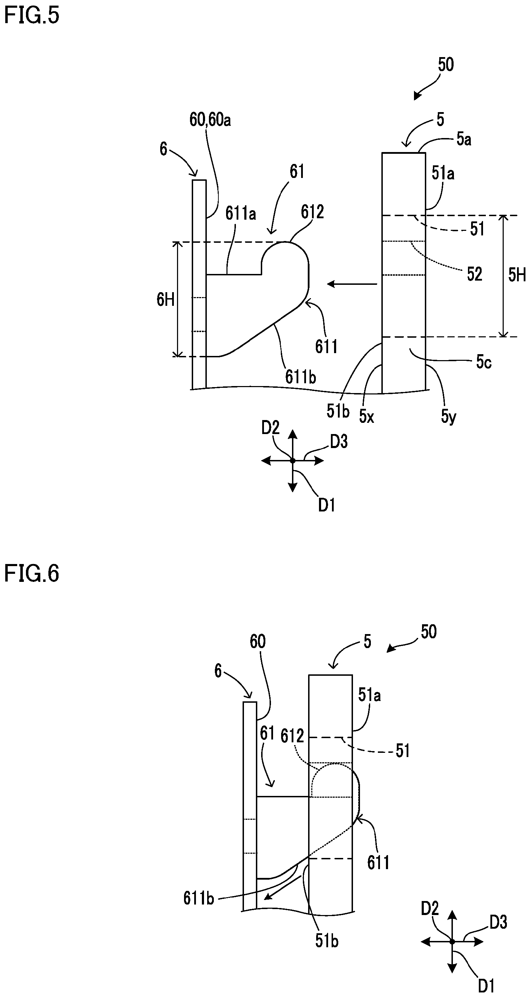

The hook 61 has a protruding base portion 611 and a separation restricting portion 612 (see FIGS. 3 and 5). The protruding base portion 611 protrudes from the mounting surface (60) 60 and supports the supported portion 51a of the circuit board 5 (see FIG. 7).

The separation restricting portion 612 protrudes upward from a tip-end portion of the protruding base portion 611 (see FIGS. 3 and 5 to 7). The separation restricting portion 612 restricts the movement of the supported portion 51a supported by the protruding base portion 611 in a direction away from the mounting surface (60) 60 (see FIG. 7). In other words, the separation restricting portion 612 is a retaining portion that restricts the hook 61 from coming out of the hanging hole 51.

An upper edge portion of a portion of the protruding base portion 611 between the mounting surface (60) 60 and the separation restricting portion 612 is a support portion 611a that supports the supported portion 51a of the circuit board 5 (see FIG. 7). The support portion 611a is formed along the depth direction D3.

The circuit board 5, by being supported by the hook 61 at the supported portion 51a and restricted by the separation restricting portion 612, is positioned at the mounting position.

A vertical dimension 5H of the hanging hole 51 of the circuit board 5 is larger than a vertical dimension 6H of the hook 61 (see FIGS. 4 and 5). The vertical dimension 5H is the dimension of the hanging hole 51 of the circuit board 5 in the first direction D10. The vertical dimension 6H is the dimension of the hook 61 in the vertical direction D1.

Similarly, the horizontal dimension 5W of the hanging hole 51 of the circuit board 5 is larger than the horizontal dimension 6W of the hook 61 (see FIG. 4). The horizontal dimension 5W is the dimension of the hanging hole 51 of the circuit board 5 in the second direction D20. The horizontal dimension 6W is the dimension of the hook 61 in the width direction D2.

In the circuit board mounting structure 50, a plurality of wire harnesses 8 are wired. Each of the wire harnesses 8 includes a plurality of electric wires 80 and a connector 81 connected to one end of the plurality of electric wires 80 (see FIG. 2).

The plurality of wire harnesses 8 are wired from the mounting portion (6) 6 side to the second surface 5y of the circuit board 5 via the outer sides of the third side (5c) 5c and the fourth side (5d) 5d of the circuit board 5 (see FIG. 2).

A plurality of connectors 54 are mounted on the second surface 5y of the circuit board 5 (see FIG. 2). The connectors 81 of the plurality of wire harnesses 8 are connected to the plurality of connectors 54 (see FIG. 2).

In the present embodiment, the circuit board 5 has a fitting hole 53 formed in a portion of the edge portion along the second side (5b) 5b near the third side (5c) 5c (see FIGS. 2, 8 and 9). On the other hand, the mounting portion (6) 6 has a fitting protrusion 64 protruding from the mounting surface (60) 60 (see FIGS. 2, 8 and 9). The fitting protrusion 64 fits into the fitting hole 53.

The circuit board 5 is supported by the hook 61 at the supported portion 51a, and the fitting protrusion 64 fits into the fitting hole 53, whereby the circuit board 5 is positioned at the mounting position with high accuracy.

In the present embodiment, the mounting portion (6) 6 is a sheet metal member. The fitting protrusion 64 is a protrusion formed by half punch processing. Thus, no burrs are formed on the fitting protrusion 64, and the circuit board 5 is prevented from being damaged by contact with the fitting protrusion 64.

The hook 61 is a portion formed by bending a part of a metal plate along the depth direction D3. The separation restricting portion 612 of the hook 61 has a curved contour. Thus, the circuit board 5 is prevented from being damaged due to contact with the separation restricting portion 612.

In the present embodiment, the mounting surface (60) 60 includes a plurality of unit mounting surfaces (60) formed at intervals in the vertical direction D1 and the width direction D2. The mounting surface (60) 60 includes a first mounting surface (60) 60a formed near a first end of the mounting portion (6) 6 in the width direction D2, and a second mounting surface (60) 60b formed near a second end of the mounting portion (6) 6 in the width direction D2 (see FIG. 2).

In FIG. 2, the end on the left side when facing the sheet is the first end in the width direction D2, and the end on the right side when facing the sheet is the second end in the width direction D2. The hook 61 protrudes from the first mounting surface (60) 60a along the depth direction D3.

When the circuit board 5 is brought close to the mounting surface (60) 60 in a state in which the first direction D10 of the circuit board 5 is aligned with the vertical direction D1, the hook 61 is inserted into the hanging hole 51 and the supported portion 51a is placed on the protruding base portion 611.

In the following description, of the plurality of wire harnesses 8, a portion that is wired at the first end side of the mounting portion (6) 6 is referred to as a first wire harness 8a, and a portion that is wired at the second end side of the mounting portion (6) 6 is referred to as a second wire harness 8b (see FIGS. 2, 10, and 11).

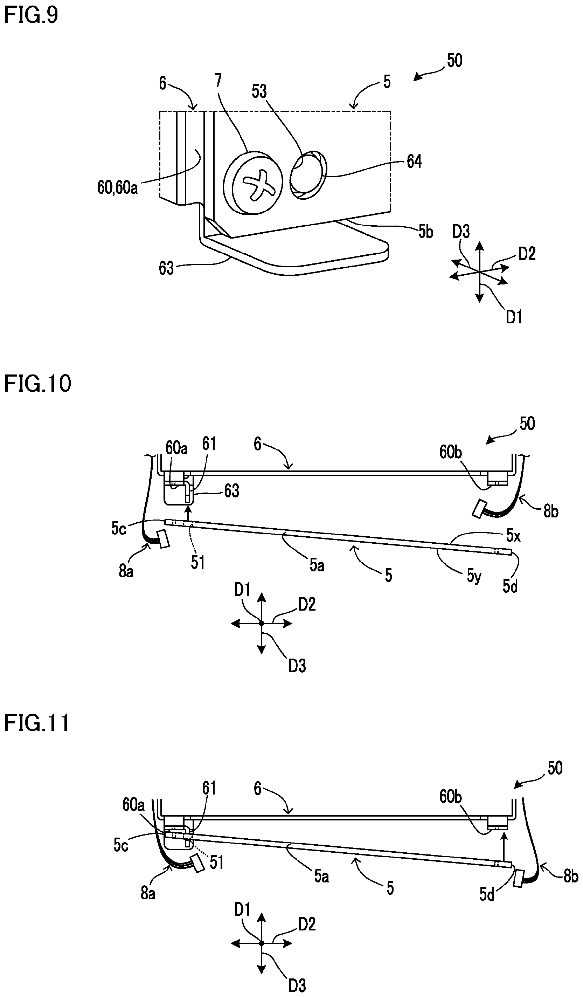

When the circuit board 5 is mounted to the mounting portion (6) 6, the circuit board 5 is brought close to the mounting portion (6) 6 along the depth direction D3 with the first side (5a) 5a of the circuit board 5 facing upward and the first direction D10 of the circuit board 5 aligned along the vertical direction D1 (see FIG. 10).

In addition, the circuit board 5, in a state of being tilted in the depth direction D3 so that the third side (5c) 5c is closer to the mounting portion (6) 6 than the fourth side, is brought close to the mounting portion (6) 6. At that time, the third side (5c) 5c of the circuit board 5 is brought close to the first mounting surface (60) 60a while avoiding the first wire harness 8a.

When the third side (5c) 5c of the circuit board 5 is brought close to the first mounting surface (60) 60a, the hook 61 is inserted into the hanging hole 51 and the supported portion 51a is placed on the supporting portion 611a of the protruding base portion 611 (see FIGS. 6, 7 and 11).

In this embodiment, a lower edge portion of the protruding base portion 611 of the hook 61 serves as a guiding portion 611b that guides a part of the circuit board 5 in a predetermined direction (see FIGS. 3, 5 and 6). The guiding portion 611b is inclined obliquely downward from the tip-end side to the base side of the protruding base portion 611.

An edge portion on the second side (5b) 5b side of the hanging hole 51 in the circuit board 5 is a guided portion 51b that is guided by a guiding portion 611b (see FIGS. 5 and 6).

By bringing the third side (5c) 5c of the circuit board 5 closer to the mounting portion (6) 6 than the fourth side (5d) 5d of the circuit board 5, the worker can first focus on ensuring that the first wire harness 8a does not get pinched between the mounting portion (6) 6 and the circuit board 5.

When the hook 61 is inserted into the hanging hole 51 by bringing the circuit board 5 close to the mounting surface (60) 60 in a state in which the first direction D10 of the circuit board 5 is aligned with the vertical direction D1, the guiding portion 611b guides the guided portion 51b of the circuit board 5 diagonally downward (see FIG. 6). Thus, the circuit board 5 approaches the mounting position in the vertical direction D1, and the supported portion 51 a of the circuit board 5 is placed on the supporting portion 611a of the hook 61.

By placing the supported portion 51a on the supporting portion 611a of the protruding base portion 611, the circuit board 5 is positioned approximately at the mounting position in the vertical direction D1 and the width direction D2.

After the supported portion 51a is placed on the supporting portion 611a, the fourth side (5d) 5d of the circuit board 5 is brought close to the second mounting surface (60) 60b while avoiding the second wire harness 8b (see FIG. 11). Thus, the fitting protrusion 64 and the fitting hole 53 are fitted together, and the entire circuit board 5 is positioned at the mounting position.

When the fourth side (5d) 5d of the circuit board 5 is brought close to the second mounting surface (60) 60b after the supported portion 51a is supported by the supporting portion 611a, the worker can focus on ensuring that the second wire harness 8b is not pinched between the mounting portion (6) 6 and the circuit board 5.

After the entire circuit board 5 is positioned at the mounting position, a plurality of screws 7 are inserted into the plurality of screw insertion holes 52 and fastened into the plurality of fastening holes 62.

A first screw insertion hole 52a, which is one of the plurality of screw insertion holes 52, is formed between the hanging hole 51 and the third side (5c) 5c of the circuit board 5 (see FIG. 4).

The plurality of fastening holes 62 include a first fastening hole 62a that corresponds to the first screw insertion hole 52a (see FIGS. 3 and 4). The first fastening hole 62a is formed adjacent to the hook 61 in the width direction D2 (see FIGS. 3 and 4).

For example, one of the plurality of screws 7 is fastened into the first fastening hole 62a via the first screw insertion hole 52a, whereby the circuit board 5 is temporarily fixed at the mounting position.

A second screw insertion hole 52b, which is another one of the plurality of screw insertion holes 52, is formed between the fitting hole 53 and the third side (5c) 5c of the circuit board 5 (see FIGS. 8 and 9).

The plurality of fastening holes 62 include a second fastening hole 62b corresponding to the second screw insertion hole 52b (see FIG. 8). The second fastening hole 62b is formed adjacent to the fitting protrusion 64 in the width direction D2 (see FIG. 8).

The second of the plurality of screws 7 is fastened into the second fastening hole 62b via the second screw insertion hole 52b whereby the circuit board 5 is temporarily fixed at the mounting position with higher accuracy.

By adopting the circuit board mounting structure 50, it is possible to easily mount the circuit board 5 on the mounting surface (60) 60 along the vertical direction D1 while preventing the electric wires 80 of the plurality of wire harnesses 8 from being pinched between the circuit board 5 and the mounting portion (6) 6.

### [Supplementary Notes of the Invention]

An outline of the invention extracted from the above-described embodiment will be added below. Note that the configurations and processing functions described in the following supplementary notes can be selected and combined as desired.

### <Supplementary Note 1>

A circuit board mounting structure, including:
a circuit board configured to have a first side (5a) and a second side (5b) forming both edges in a first direction, and a third side (5c) and a fourth side (5d) forming both edges in a second direction crossing the first direction;
a mounting portion (6) configured to have a mounting surface (60) formed along an up-down direction, to which the circuit board is attached in a state in which the first side (5a) of the circuit board faces upward and the first surface of the circuit board faces the mounting surface (60); and
a plurality of screws configured to fix the circuit board to the mounting portion (6); wherein
the circuit board has
   a hanging hole formed in a portion of an edge portion along the first side (5a) close to the third side (5c), through which a part of the mounting portion (6) is inserted; and
   a plurality of screw insertion holes through which the plurality of screws are inserted;
the mounting portion (6) has
   a hook configured to protrude from the mounting surface (60) and to be inserted into the hanging hole to support a supported portion that is an edge portion of the hanging hole on the first side (5a) side of the circuit board;
   a plurality of fastening holes into which the plurality of screws inserted into the plurality of screw insertion holes of the circuit board are fastened; and
   a rotation restricting portion configured to restrict rotation of the circuit board about the hook inserted through the hanging hole by coming in contact with an outer edge of the circuit board in a state in which the hook supports the supported portion of the circuit board;
the hook has
   a protruding base portion configured to protrude from the mounting surface (60) and support the supported portion of the circuit board; and
   a separation restricting portion configured to protrude upward from a tip-end portion of the protruding base portion and to restrict movement of the supported portion supported by the protruding base portion in a direction away from the mounting surface (60);
a dimension of the hanging hole in the first direction of the circuit board is larger than a dimension of the hook in the up-down direction;
a plurality of wire harnesses are wired from the mounting portion (6) side to a second surface of the circuit board via the outer sides of the third side (5c) and the fourth side (5d) of the circuit board; and
by bringing the circuit board close to the mounting surface (60) in a state in which the first direction of the circuit board is aligned in the up-down direction, the hook is inserted into the hanging hole and the supported portion is placed on the protruding base portion.

### <Supplementary Note 2>

The circuit board mounting structure according to Supplementary Note 1, wherein
the circuit board has a fitting hole formed in a portion of an edge portion along the second side (5b)near the third side (5c); and
the mounting portion (6) has a fitting protrusion configured to protrude from the mounting surface (60) and fit into the fitting hole.

### <Supplementary Note 3>

The circuit board mounting structure according to Supplementary Note 2, wherein
the mounting portion (6) is a sheet metal member; and
the fitting protrusion is a protrusion formed by half punch processing.

### <Supplementary Note 4>

The circuit board mounting structure according to any one of Supplementary Notes 1 to 3, wherein
a lower edge portion of the protruding base portion forms a guiding portion that is inclined obliquely downward from a tip-end side toward a base side of the protruding base portion; and
when the hook is inserted into the hanging hole by bringing the circuit board close to the mounting surface (60) in a state in which the first direction of the circuit board is aligned in the up-down direction, the guiding portion guides a guided portion, which is an edge portion of the second side (5b) side of the hanging hole in the circuit board, diagonally downward.

### <Supplementary Note 5>

The circuit board mounting structure according to any one of Supplementary Notes 1 to 4, wherein
one of the plurality of screw insertion holes is formed between the hanging hole and the third side (5c) of the circuit board.

### <Supplementary Note 6>

The circuit board mounting structure according to any one of Supplementary Notes 1 to 5, wherein
the rotation restricting portion comes in contact with the second side (5b) of the circuit board.

### <Supplementary Note 7>

The circuit board mounting structure according to any one of Supplementary Notes 1 to 6, wherein
the first direction of the circuit board is the longitudinal direction of the circuit board.

### <Supplementary Note 8>

An image forming apparatus including:
a sheet conveying device configured to convey a sheet;
a printing device configured to form an image on the conveyed sheet; and
a circuit board mounting structure according to any one of Supplementary Notes 1 to 7 for mounting a circuit board configured to control the sheet conveying device or the printing device.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. A circuit board mounting structure (50), comprising:
a circuit board (5) configured to have a first side (5a) and a second side (5b) forming both edges in a first direction, and a third side (5c) and a fourth side (5d) forming both edges in a second direction crossing the first direction;
a mounting portion (6) configured to have a mounting surface (60) formed along an up-down direction, to which the circuit board (5) is attached in a state in which the first side (5a) of the circuit board (5) faces upward and the first surface of the circuit board (5) faces the mounting surface (60); and
a plurality of screws (7) configured to fix the circuit board (5) to the mounting portion (6); wherein
the circuit board (5) has
a hanging hole (51) formed in a portion of an edge portion along the first side (5a) close to the third side (5c), through which a part of the mounting portion (6) is inserted; and
a plurality of screw insertion holes (52) through which the plurality of screws (7) are inserted;
the mounting portion (6) has
a hook (61) configured to protrude from the mounting surface (60) and to be inserted into the hanging hole (51) to support a supported portion (51a) that is an edge portion of the hanging hole (51) on the first side (5a) of the circuit board (5);
a plurality of fastening holes (62) into which the plurality of screws (7) inserted into the plurality of screw insertion holes (52) of the circuit board (5) are fastened; and
a rotation restricting portion (63) configured to restrict rotation of the circuit board (5) about the hook (61) inserted through the hanging hole (51) by coming in contact with an outer edge of the circuit board (5) in a state in which the hook (61) supports the supported portion (51a) of the circuit board (5);
the hook (61) has
a protruding base portion (611) configured to protrude from the mounting surface (60) and support the supported portion (51a) of the circuit board (5); and
a separation restricting portion (612) configured to protrude upward from a tip-end portion of the protruding base portion (611) and to restrict movement of the supported portion (51a) supported by the protruding base portion (611) in a direction away from the mounting surface (60);
a dimension of the hanging hole (51) in the first direction of the circuit board (5) is larger than a dimension of the hook (61) in the up-down direction;
a plurality of wire harnesses are wired from the mounting portion (6) side to a second surface of the circuit board (5) via the outer sides of the third side (5c) and the fourth side (5d) of the circuit board (5); and
by bringing the circuit board (5) close to the mounting surface (60) in a state in which the first direction of the circuit board (5) is aligned in the up-down direction, the hook (61) is inserted into the hanging hole (51) and the supported portion (51a) is placed on the protruding base portion (611).

2. The circuit board mounting structure (50) according to claim 1, wherein
the circuit board (5) has a fitting hole (53) formed in a portion of an edge portion along the second side (5b) near the third side (5c); and
the mounting portion (6) has a fitting protrusion (64) configured to protrude from the mounting surface (60) and fit into the fitting hole (53).

3. The circuit board mounting structure (50) according to claim 2, wherein
the mounting portion (6) is a sheet metal member; and
the fitting protrusion (64) is a protrusion formed by half punch processing.

4. The circuit board mounting structure (50) according to any one of claims 1 to 3, wherein
a lower edge portion of the protruding base portion (611) forms a guiding portion (611b) that is inclined obliquely downward from a tip-end side toward a base side of the protruding base portion (611); and
when the hook (61) is inserted into the hanging hole (51) by bringing the circuit board (5) close to the mounting surface (60) in a state in which the first direction of the circuit board (5) is aligned in the up-down direction, the guiding portion (611b) guides a guided portion (51b), which is an edge portion of the second side (5b) side of the hanging hole (51) in the circuit board (5), diagonally downward.

5. The circuit board mounting structure (50) according to any one of claims 1 to 4, wherein
one of the plurality of screw insertion holes (52) is formed between the hanging hole (51) and the third side (5c) of the circuit board (5).

6. The circuit board mounting structure (50) according to any one of claims 1 to 5, wherein
the rotation restricting portion (63) comes in contact with the second side (5b) of the circuit board (5).

7. The circuit board mounting structure (50) according to any one of claims 1 to 6, wherein
the first direction of the circuit board (5) is the longitudinal direction of the circuit board (5).

8. An image forming apparatus (10), comprising:
a sheet conveying device (3) configured to convey a sheet;
a printing device (4) configured to form an image on the conveyed sheet; and
a circuit board mounting structure (5) according any one of claims 1 to 7 for mounting a circuit board (5) configured to control the sheet conveying device (3) or the printing device (4).
